# EUROPEAN PATENT APPLICATION

(11) **EP 4 020 086 A1**
(43) Date of publication of application: **29.06.2022**
(21) Application number: 20217444.7
(22) Date of filing: 28.12.2020
(51) Int. Cl.: G03F 7/20, G03F 9/00

(54) **A METROLOGY APPARATUS AND A METROLOGY METHOD**

(71) Applicant: ASML Netherlands B.V., 5500 AH Veldhoven (NL)
(72) Inventor: RAAYMAKERS, Jeroen Arnoldus Leonardus Johannes, 5500 AH Veldhoven (NL); LOMANS, Bram Antonius Gerardus, 5500 AH Veldhoven (NL)
(74) Representative: ASML Netherlands B.V.

(57) **Abstract**

The present disclosure relates to a metrology apparatus for measuring a parameter of interest of a targets on a substrate comprising:
- m x n detectors, wherein m≥1 and n≥1 ;
- a first frame; and
- (n-1) second frames; and
- m x n intermediate frames
wherein:
- each detector comprises a first and a second fine positioning system configured to position the detector in a first and a second direction, respectively, each detector via the first and second fine positioning system being connected to one intermediate frame;
- each of the (m-1) x n intermediate frames comprises a second coarse positioning system for positioning the detector in the first direction, each intermediate frame being connected to one of the first or second frames; and
- each second frame comprises a first coarse positioning system for positioning the one or more second frames in the second direction.

## Description

### FIELD

The present disclosure relates to a metrology apparatus for measuring a parameter of a target fabricated on a substrate using a lithographic apparatus. The present disclosure further relates to a corresponding metrology method.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In manufacturing processes of integrated circuits (ICs), targets or alternatively referred to as marks, may be provided on the substrate along with unfinished or finished circuit components. By measuring the position and/or other parameters of these targets using a metrology apparatus, it can be determined whether circuit components are accurately positioned on the substrate, for instance relative to previously manufactured device features, i.e. overlay, and/or to ensure that they are manufactured according to design and are free of defects. Metrology apparatus utilizing optical (e.g. scatterometric or interferometric) measurement systems can be employed.

Typically, the metrology apparatus includes a measurement frame, a substrate table for holding a substrate, a substrate positioning system for positioning the substrate table relative to the measurement frame and a detector mounted to the measurement frame. A substrate is positioned on a substrate table, and the substrate table is positioned using the substrate positioning system to align a target with the detector for a measurement.

A drawback of the current metrology apparatus is that throughput is limited and decreases when the number of targets to be measured on the substrate increases.

### SUMMARY

Considering the above, it is an object of the invention to provide a metrology apparatus and corresponding method with an improved throughput.

According to an embodiment of the invention, there is provided a metrology apparatus for measuring a parameter of interest of a targets on a substrate comprising:
- m x n detectors, wherein m≥1 and n≥1;
- a first frame;
- (n-1) second frames; and
- m x n intermediate frames,
wherein:
- each detector comprises a first fine positioning system configured to position the detector in a first direction and a second fine positioning system configured to position the detector in a second direction, each detector via the first fine positioning system and the second fine positioning system being connected to one intermediate frame;
- each of the (m-1) x n intermediate frames comprises a second coarse positioning system for positioning the detector in the first direction, each intermediate frame being connected to one of the first or second frames; and
- each second frame comprises a first coarse positioning system for positioning the one or more second frames in the second direction.

According to another embodiment of the invention, there is provided a lithographic system comprising a metrology apparatus according to the invention.

According to a further embodiment of the invention, there is provided a method for measuring a parameter of interest of a targets on a substrate using a metrology apparatus comprising m x n detectors, wherein m≥1 and n≥1, a first frame, (n-1) second frames and m x n intermediate frames, wherein each detector is connected to one intermediate frame, wherein each intermediate frame is connected to one of the first or second frames comprising the following steps:
a. positioning the (n-1) second frames relative to the first frame;
b. positioning a substrate relative to the first frame and the (n-1) second frames;
c. positioning the (m-1) x n intermediate frames relative to the first and the (n-1) second frames; and
d. measuring the parameter of interest.

### BRIEF DESCRIPTION OF THE DRAWINGS

Embodiments of the present disclosure will now be described, by way of example only, with reference to the accompanying schematic drawings, in which:
- Figure 1 depicts a schematic overview of a lithographic apparatus according to an embodiment;
- Figure 2 depicts a schematic diagram illustrating an exemplary metrology apparatus, consistent with embodiments of the present disclosure;
- Figure 3 schematically depicts an exemplary measurement system according to the invention suitable for the metrology apparatus of Fig. 2; and
- Figure 4 schematically depicts an exemplary distribution of targets over a top surface of a substrate according to the invention.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented, and only the differences with respect to the individual embodiments are described. The implementations set forth in the following description of exemplary embodiments do not represent all implementations. Instead, they are merely examples of apparatuses and methods consistent with aspects related to the disclosed embodiments as recited in the appended claims.

Relative dimensions of components in drawings may be exaggerated for clarity. As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

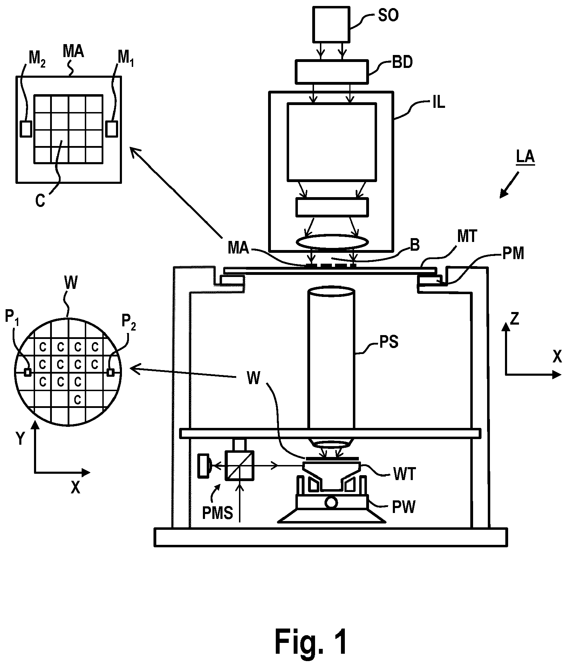

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axis is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

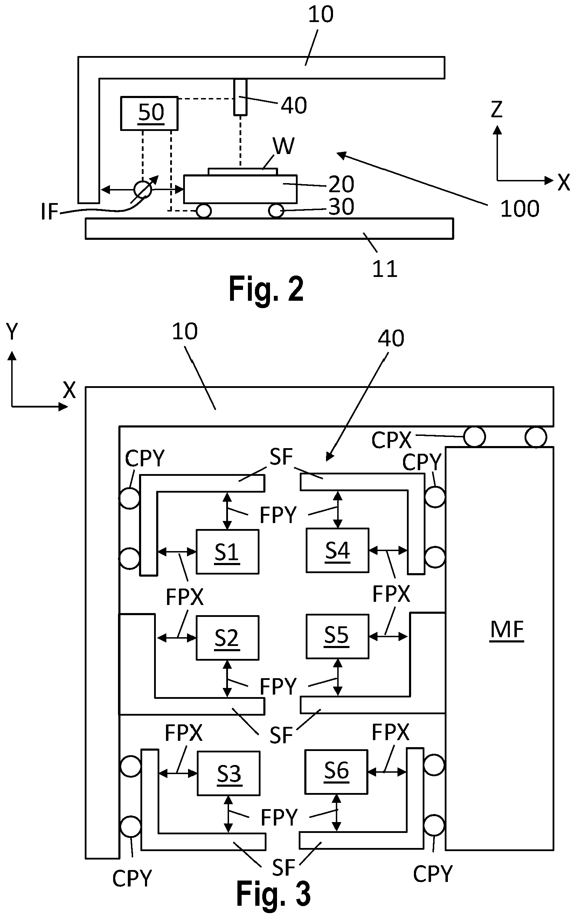

Reference is now made to Fig. 2, which illustrates an exemplary metrology apparatus 100 consistent with embodiments of the present disclosure. As shown in Fig. 2, metrology apparatus 100 includes a measurement frame 10, a substrate table 20, a substrate positioning system 30, a measurement system 40 and a control unit 50 configured to control the measurement system and the substrate positioning system. The measurement frame 10 may alternatively be referred to as first frame 10.

The measurement system 40 is mounted to the measurement frame 10. The substrate table 20 is configured to hold a substrate W. The substrate positioning system 30 is configured to position the substrate table 20 relative to the measurement frame 10 and thus the measurement system 40. An interferometer IF may be provided to measure a position of the substrate table 20 relative to the measurement frame 10. The control unit 50 is in this embodiment configured to drive the substrate positioning system 30 to apply forces to the substrate table 20 based on an output of the interferometer IF. The forces may be applied between a frame 11 separate from the measurement frame 10 and the substrate table 20 to minimize the disturbances to the measurement frame 10 and thus the measurement system 40. The substrate positioning system 30 may thus be used to align targets on the substrate W with the measurement system 40.

Fig. 3 depicts an exemplary embodiment of a measurement system 40 according to the invention suitable to be used in the metrology apparatus 100 of Fig. 2. Fig. 3 depicts the measurement system 40 in an X-Y plane which is perpendicular to the Z-direction as shown in Fig. 2.

In this example, the measurement system 40 comprises a plurality of six detectors S1-S6 arranged in an m x n array, with m being the number of detectors in Y-direction, in this embodiment 3, and n being the number of detectors in X-direction, in this embodiment 2. A benefit of a plurality of detectors is that a plurality of targets can be readout, i.e. measured, simultaneously thereby improving throughput. However, that benefit can only be achieved when two or more detectors can be aligned simultaneously with respective targets on the substrate and can simultaneously measure said targets. To this end, the measurement system is provided with a fine positioning assembly including a first fine positioning system and a second fine positioning system per detector S1-S6 configured to position said detectors S1-S6 in X- and Y-direction, respectively, and a coarse positioning assembly including a first coarse positioning system and a second coarse position system arranged between the fine positioning assembly and the measurement frame 10 and configured to position frames supporting one or more detectors S1-S6 in the X- or Y-direction as will be explained below in more detail. A benefit of this stacked configuration of measurement frame 10, coarse positioning assembly, fine positioning assembly and detectors S1-S6 is that the coarse positioning assembly and the fine positioning assembly can be dedicated to different requirements and/or performances resulting in a more efficient measurement system which may improve throughput as well.

A method for measuring a parameter of interest of one or more targets on one or more substrates using the metrology apparatus 100 of Fig. 2 includes at least two phases, namely a positioning phase in which one or more detectors S1-S6 are aligned with one or more targets on the substrate, and a measuring phase in which the parameter of interest is measured, directly or indirectly. In case the parameter of interest is measured indirectly, the method may further include a processing phase to process data, e.g. an image, obtained from the detector to determine the parameter of interest. The sequence of positioning phase and measuring phase may be repeated as many times as necessary, wherein a processing phase, if applicable, may take place simultaneously with a subsequent positioning phase.

During the positioning phase, the control unit 50 may drive the substrate positioning system 30, the first positioning assembly and/or the second positioning assembly depending on the distribution of the targets to be measured on the substrate W. A substrate W typically comprises a plurality of fields, i.e. target portions C in Fig. 1, each field corresponding to an integrated circuit or device, having a specific field size. Targets to be measured may be distributed on the substrate in accordance with the field size, e.g. using scribe-lane targets when these are located between or at the border of the fields. Hence, by roughly positioning the detectors S1-S6 at a mutual distance matching the field size or a multiple thereof, moving the substrate W relative to the measurement system 40 may allow different sets of targets on the substrate W to be positioned in near alignment with the detectors S1-S6. The coarse positioning system adjusts the pitch between the detectors to roughly match the field pitch or distance between the targets to be measured. Generally the range of the coarse positioning system may in the order if 10 to 30 millimeters, which enables the detector to move in a range of the field pitch of the substrate to be measured. When deviations exist between the mutual distance between targets on the substrate and the set mutual distance of the detectors S1-S6, the detectors itself can be positioned to align one or more of the detectors S1-S6 relative to one or more targets. Deviations may be caused by misalignments and thermal drifts, but may also be deliberate introduced deviations during processing of the substrate W. The mutual distance between the detectors S1-S6 may be set by the coarse positioning assembly so that the positioning systems of the fine positioning assembly may be used to compensate for deviations from the set mutual distance. The fine positioning assembly generally corrects for small target to target positioning inaccuracies and may in the order of a few millimeters, e.g. 0 to 5 millimeters.

Usually, the deviations from the set mutual distance are smaller than the mutual distance itself, so that the moving range of the fine positioning systems may be smaller than the moving range of the coarse positioning systems. Compared to the coarse positioning assembly, the fine positioning assembly may have one or more, preferably all, of the following characteristics:
1. a significantly smaller moving range;
2. a significantly more accurate positioning performance;
3.a significantly finer positioning performance.

Referring to Fig. 3 again, each detector S1-S6 is connected to an associated intermediate frame SF via a first fine positioning system FPX and a second fine positioning system FPY of the fine positioning assembly.

Each first fine positioning system FPX is configured for moving a respective detector S1-S6 in X-direction relative to the respective intermediate frame SF. Each second fine positioning system FPY is configured for moving a respective detector S1-S6 in Y-direction relative to the respective intermediate frame SF. As a result thereof, the detectors S1-S6 are moveable in two orthogonal directions, i.e. X- and Y-direction parallel to a top surface of the substrate W and can thus align within its moving range to a target on the substrate.

The coarse positioning assembly is configured to set a distance between the respective intermediate frames SF associated with the detectors S1-S6, in particular to set a pitch in X-direction and a pitch in Y-direction. Ideally, the coarse positioning assembly sets a pitch between the detectors S1-S6 in the positioning phase prior to the measuring phase and keeps this pitch constant during subsequent sequences of positioning phases and measuring phases, so that the coarse positioning assembly may only be used once per lot or a plurality of similar lots. Since the coarse positioning assembly is used relatively low frequently, the design of the coarse positioning system may performed for relatively low speed and/or low-performance applications, such as a roller bearing. The fine positioning systems may be used during each positioning phase of positioning the detector S1-S6 with respect to the target. The fine positioning assembly needs to position the detector S1-S6 more accurately above the target and requires therefore a faster responding and/or moving items which may also have a higher performance, such as a flexure-based design.

Due to the 3 x 2 arrangement of the detectors S1-S6, the plurality of detectors S1-S6 can be divided into two subgroups. In this example, a first subgroup is formed by detectors S1-S3 and a second subgroup is formed by detectors S4-S6. A distance in X-direction between the intermediate frames SF of the first subgroup and the intermediate frames SF of the second subgroup can be set by a first coarse positioning system CPX that is operational between the first frame 10 and a second frame MF to which the intermediate frames SF of the second subgroup are mounted. By moving the second frame MF, the intermediate frames associated with detectors S4-S6 are moved as a group in X-direction.

To set a distance in Y-direction between the intermediate frames SF, second coarse positioning systems CPY are provided that operate on two of the three intermediate frames SF of each subgroup, namely intermediate frames SF of detectors S1, S3, S4 and S6. For the first subgroup, the second coarse positioning systems CPY are arranged between the respective intermediate frame SF and the measurement frame 10. For the second subgroup, the second coarse positioning systems CPY are arranged between the respective intermediate frame SF and the second frame MF. The intermediate frame SF associated with detector S2 is mounted to or integral with the first frame 10 so that only two of the three intermediate frames SF are moveable in Y-direction by the second coarse positioning systems. The intermediate frame SF associated with detector S5 is mounted to or integral with the first frame 10 so that only two of the three intermediate frames SF are moveable in Y-direction by the second coarse positioning systems.

As a general rule, the number of intermediate frames SF in a row or column minus one need to be moveable in a particular direction to be able to set a distance between all detectors S1-S6 in said row or column in said particular direction. In this embodiment, the intermediate frames SF of the second subgroup are moveable in X-direction relative to the first frame 10 using the first coarse positioning system CPX while the intermediate frames SF of the first subgroup are not moveable, i.e. stationary, in X-direction. Within a subgroup of detectors, one intermediate frame SF is not moveable in Y-direction while the other two intermediate frames SF are moveable in Y-direction. As a result thereof, a pitch in X-direction and a pitch in Y-direction can be set by the coarse positioning assembly using five coarse positioning systems, namely one first coarse positioning system CPX and four second coarse positioning systems CPY. When three detectors are provided in a row or column, an intermediate frame S associated with the middle detector is preferably stationary, i.e. mounted to or integral with the first frame 10 or the second frame MF. This has the benefit that a symmetrical configuration is obtained in which a distance between the moveable intermediate frames SF and the stationary intermediate frame SF may be equal and thus the second coarse positioning systems CPY can be driven in a similar way to set a mutual distance between all intermediate frames SF in said row or column. For instance, in the embodiment of Fig. 3, the pitch in Y-direction between all intermediate frames SF may be Y1 as depicted in Fig. 3. Changing the pitch to Y1+ΔY requires the intermediate frames SF of detectors S1 and S4 to move ΔY in positive Y-direction and requires intermediate frames SF of detectors S3 and S6 to move ΔY in negative Y-direction. Hence, with a single degree of freedom, the control unit 50 is able to drive the second coarse positioning systems to set a mutual distance between the intermediate frames SF. However, it is also envisaged that the second coarse positioning systems CPY each have their own dedicated drive signal resulting in additional degrees of freedom.

Although in the above example, six detectors in a 3 x 2 array are described, it will be apparent that the invention can also be applied to other number of detectors as well. An advantage of the proposed architecture is that it is highly scalable. For instance, the prior art measurement systems with a single stationary detector could initially be replaced or extended to the first subgroup of detectors as shown in Fig. 3 without the second subgroup. Subsequently, the second subgroup of detectors could be added, but the principle could also be applied to 4 x 2 detectors or 3 x 3 detectors. In fact, the principle can be applied to any array of m x n detectors, with m and n being integer values of at least one.

Further, the above examples mention an m x n array wherein a detector is provided for each element of the array. It is envisaged that the plurality of detectors may also be arranged in accordance with an m x n array, but only using some of the elements of the array, so that for instance other patterns like a cross are possible. It is also envisaged that the plurality of detectors is arranged in accordance with a pattern that does not fit into an m x n array.

The coarse positioning assembly is preferably used to set a distance between the detectors to match with a field size of the targets on the substrate, or a multiple thereof, as the marks are likely to be placed in a grid corresponding to the field size of the targets. The substrate positioning system is then used to position a substrate with marks relative to the detectors. The fine positioning systems can then be used to accurately and fine align the detectors with the marks e.g. to compensate for misalignments and/or thermal drifts. This will increase throughput for both dense and sparse mark distributions.

Although not depicted, the fine and/or coarse positioning systems may be provided with a position sensor, e.g. an encoder scale, to provide position feedback.

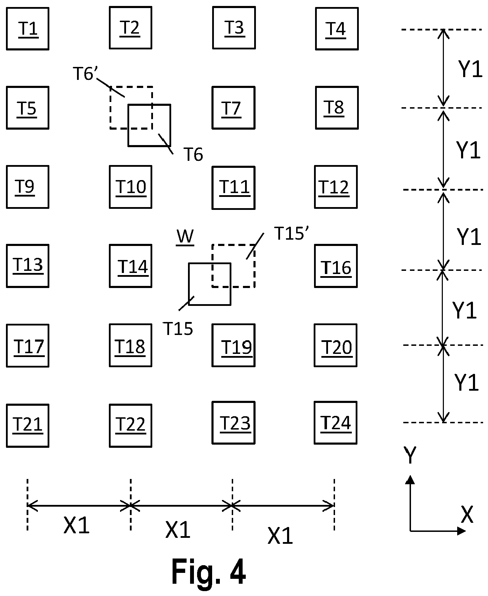

Fig. 4 schematically depicts a top view of a portion of a top surface of a substrate W showing a plurality of targets T1 - T24 arranged in an b x d array with b being the number of targets in Y-direction, in this embodiment six and d the number of targets in X-direction, in this embodiment being four and all elements in the array being provided with a corresponding target.

A pitch in Y-direction of the array is Y1 and a pitch in X-direction of the array is XI. As an example, two targets, namely target T6 and target T15 have been depicted in a position that deviates from the array position. The respective array positions T6' and T15' have been indicated in dashed lines to indicate the deviation.

In a prior art method, a measurement system with a single stationary detector is used. A substrate positioning system such as the substrate positioning system 30 in Fig. 2 is used during a positioning phase to align one of the targets T1-T24 with a detector of the measurement system. Subsequently, information from the target is obtained during a measuring phase. Possibly, the information needs to be processed during a processing phase, which processing phase may take place concurrently with a subsequent positioning phase. A sequence relating to one target thus has to be repeated for all targets resulting in this example in 24 sequences of positioning and measuring.

With the present invention using a measurement system 40 as depicted in Fig. 3, the coarse positioning assembly is used during an initial positioning phase to set a mutual distance between the intermediate frames SF in Y-direction to Y1 and to set a mutual distance between the intermediate frames SF in X-direction to XI to match the pitches of the array on the substrate. Further, the plurality of detectors may be positioned over a first set of targets, for instance the targets T1, T2, T5, T6, T9 and T10, using the substrate positioning system. In this example, due to the deviation of target T6, it is not possible to align all targets with a corresponding detector, so that a fine positioning system is used to move a support in X- and Y-direction to align the detector with target T6. The other fine positioning systems may also have to be used to compensate for smaller deviations not depicted in Fig. 4. Once the detectors are aligned with the first set of targets, the measuring phase can commence to obtain information from the targets.

After the measuring phase, a subsequent positioning phase starts in order to align the detectors with a second set of targets, e.g. the targets T3, T4, T7, T8, T11 and T12, using the substrate positioning system. The coarse positioning assembly does not have to be used as the pitch between the intermediate frames can be kept constant. Hence, the pitch is held for at least two measurements. However, the fine positioning systems need to align the detectors with the respective targets, especially as the detector previously aligned with target T6 now has to align with target T12 which has less deviation from the ideal array position than target T6. Subsequently, the process can be repeated for a third set of targets, e.g. the targets T15, T16, T19, T20, T23 and T24, taking into account the deviation of target T15, and a fourth set of targets, e.g. the targets T13, T14, T17, T18, T21 and T22.

Hence, using the measurement system according to the invention, the sequence of positioning and measuring only has to take place four times. Compared to the twenty-four times with a prior art system this is a significant improvement in throughput.

Although the above embodiment uses six detectors, other embodiments with different number of detectors may also be used. For instance, a 1 x 2 array of detectors may be used to measure the following pairs of targets in the following exemplary sequence: (T1, T2), (T3, T4), (T5, T6), (T11, T12), (T9, T10), (T7, T8), (T13, T14), (T15, T16), (T17, T18), (T23, T24), (T21, T22) and (T19, T20). In another embodiment, a 3 x 1 array of detectors may be used to measure the following combination of targets in the following exemplary sequence: (T1, T5, T9), (T2, T6, T10), (T3, T7, T11), (T4, T8, T12), (T16, T20, T24), (T15, T19, T23), (T14, T18, T22) and (T13, T17, T21).

It is to be noted that the lithographic apparatus according to Fig. 1 may be combined with a metrology apparatus according to Fig. 2 into a lithographic system allowing substrates that just have been processed by the lithographic apparatus to be measured in the metrology apparatus and possibly providing feedback to the lithographic apparatus based on the outcome at the metrology apparatus, for instance to improve overlay and/or critical dimension.

The parameter measured from a target may be its relative position, but the parameter of interest may be the relative position to a previous layer, i.e. the overlay in X- and/or in Y-direction.

Although the above described embodiments depict a measurement system in which all detectors have a corresponding fine positioning system as part of the fine positioning assembly, it is well possible that one fine positioning system is omitted. This may for instance be the case if the substrate positioning device is accurate enough to align the target to the detector lacking said fine positioning system and using the other fine positioning systems to align the other corresponding detectors with the respective targets.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a waferinspection apparatus, a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

The present disclosure has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A metrology apparatus for measuring a parameter of interest of a targets on a substrate comprising:
- m x n detectors, wherein m≥1 and n≥1;
- a first frame;
- (n-1) second frames; and
- m x n intermediate frames,
wherein:
- each detector comprises a first fine positioning system configured to position the detector in a first direction and a second fine positioning system configured to position the detector in a second direction, each detector via the first fine positioning system and the second fine positioning system being connected to one intermediate frame;
- each of the (m-1) x n intermediate frames comprises a second coarse positioning system for positioning the detector in the first direction, each intermediate frame being connected to one of the first or second frames; and
- each second frame comprises a first coarse positioning system for positioning the one or more second frames in the second direction.

2. A metrology apparatus according to claim 1, further comprising a substrate positioning system for positioning the substrate table relative to the measurement frame.

3. A metrology apparatus according to claim 1 or 2, wherein each second frame is connected to the first frame.

4. A metrology apparatus according to any of claims 1-3, wherein the first and second fine positioning systems each are a fine positioning system, and wherein the first and second positioning systems each are a coarse positioning system.

5. A metrology apparatus according to any of claims 1-4, further comprising a control unit configured to drive the fine positioning systems and the coarse positioning systems.

6. A metrology apparatus according to claim 5, wherein the control unit is configured to drive the coarse positioning systems such that prior to a measurement of a target of a substrate, a pitch between the intermediate frames is set using the coarse positioning systems, which pitch is held for at least two measurements.

7. A metrology apparatus according to claim 5 or 6, wherein the control unit is configured to drive the fine positioning systems such that prior to each measurement of a target of the substrate, the detectors are aligned with one or more targets of the substrate using the respective fine positioning systems.

8. A metrology apparatus according to any of the claims 1-7, wherein the detectors are configured to measure a position of a target on a substrate relative to another target or reference on the substrate and/or a reference external to the substrate.

9. A lithographic system comprising a metrology apparatus according to any of claims 1-8.

10. A method for measuring a parameter of interest of a targets on a substrate using a metrology apparatus comprising m x n detectors, wherein m≥1 and n≥1, a first frame, (n-1) second frames and m x n intermediate frames, wherein each detector is connected to one intermediate frame, wherein each intermediate frame is connected to one of the first or second frames comprising the following steps:
a. positioning the (n-1) second frames relative to the first frame;
b. positioning a substrate relative to the first frame and the (n-1) second frames;
c. positioning the (m-1) x n intermediate frames relative to the first and the (n-1) second frames; and
d. measuring the parameter of interest.

11. A method according to claim 10, wherein the parameter of interest comprises a position of a target on a substrate relative to another target or reference on the substrate and/or a reference external to the substrate.

12. A method according to claim 10 or 11, wherein the parameter of interest comprises a critical dimension of a target on the substrate.

13. A method according to any of claims 10-12, wherein steps a. and c. are carried out once per one or more substrates and steps b. and d. are carried out one or more times per substrate.

14. A method according to any of claims 10-13, wherein a substrate comprises a plurality of fields with a specific field size, and wherein steps a. and c. set a mutual distance between the intermediate frames to match the field size or a multiple thereof.

15. A method according to any of claims 10-14, further including the step of positioning at least one detector relative to a respective intermediate frame.
